(19) Europäisches Patentamt / European Patent Office / Office européen des brevets

(11) **EP 3 646 042 B1**

(12) **FASCICULE DE BREVET EUROPEEN**

(45) Date de publication et mention
de la délivrance du brevet:
**09.12.2020 Bulletin 2020/50**

(21) Numéro de dépôt: **18789420.9**

(22) Date de dépôt: **22.10.2018**

(51) Int Cl.:
*G01R 23/02* *(2006.01)*     *H04B 7/185* *(2006.01)*
*H04L 27/00* *(2006.01)*

(86) Numéro de dépôt international:
**PCT/EP2018/078823**

(87) Numéro de publication internationale:
**WO 2019/081392 (02.05.2019 Gazette 2019/18)**

(54) **PROCÉDE ET DISPOSITIF RÉCEPTEUR POUR L'ESTIMATION D'UN DÉCALAGE FRÉQUENTIEL ET D'UNE DÉRIVE FRÉQUENTIELLE D'UN SIGNAL UTILE**

VERFAHREN UND EMPFÄNGERVORRICHTUNG ZUR SCHÄTZUNG DES FREQUENZVERSATZES UND DER FREQUENZABWEICHUNG EINES NUTZSIGNALS

METHOD AND RECEIVER DEVICE FOR ESTIMATING A FREQUENCY OFFSET AND A FREQUENCY DRIFT OF A USEFUL SIGNAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.10.2017 FR 1760067**

(43) Date de publication de la demande:
**06.05.2020 Bulletin 2020/19**

(73) Titulaire: **Airbus Defence and Space SAS**
**31402 Toulouse Cedex 4 (FR)**

(72) Inventeurs:
- **GADAT, Benjamin**
**31402 Toulouse Cedex 04 (FR)**
- **ANTEUR, Mehdi**
**31402 Toulouse Cedex 4 (FR)**

(74) Mandataire: **Ipside**
**6, Impasse Michel Labrousse**
**31100 Toulouse (FR)**

(56) Documents cités:
CN-A- 106 817 333     US-A1- 2008 143 594
US-A1- 2013 083 872

- **LE TIAN ET AL: "An algorithm for Doppler shift and Doppler rate estimation based on pilot symbols", CONSUMER ELECTRONICS, COMMUNICATIONS AND NETWORKS (CECNET), 2012 2ND INTERNATIONAL CONFERENCE ON, IEEE, 21 avril 2012 (2012-04-21), pages 1626-1629, XP032181821, DOI: 10.1109/CECNET.2012.6201618 ISBN: 978-1-4577-1414-6**
- **GIUGNO L ET AL: "Carrier frequency and frequency rate-of-change estimators with preamble-postamble pilot symbol distribution", COMMUNICATIONS, 2005. ICC 2005. 2005 IEEE INTERNATIONAL CONFERENCE ON SEOUL, KOREA 16-20 MAY 2005, PISCATAWAY, NJ, USA,IEEE, vol. 4, 16 mai 2005 (2005-05-16), pages 2478-2482, XP010825619, DOI: 10.1109/ICC.2005.1494781 ISBN: 978-0-7803-8938-0**
- **UMBERTO MENGALI ET AL: "Data-Aided Frequency Estimation for Burst Digital Transmission", IEEE TRANSACTIONS ON COMMUNICATIONS, IEEE SERVICE CENTER, PISCATAWAY, NJ. USA, vol. 45, no. 1, 1 janvier 1997 (1997-01-01), XP011008871, ISSN: 0090-6778 cité dans la demande**

   

- **FITZ M P ED - INSTITUTE OF ELECTRICAL AND ELECTRONICS ENGINEERS: "Planar filtered techniques for burst mode carrier synchronization", COUNTDOWN TO THE NEW MILENNIUM. PHOENIX, DEC. 2 - 5, 19; [PROCEEDINGS OF THE GLOBAL TELECOMMUNICATIONS CONFERENCE. (GLOBECOM)], NEW YORK, IEEE, US, vol. -, 2 décembre 1991 (1991-12-02), pages 365-369, XP010042548, DOI: 10.1109/GLOCOM.1991.188412 ISBN: 978-0-87942-697-2 cité dans la demande**
- **LUISE M ET AL: "CARRIER FREQUENCY RECOVERY IN ALL-DIGITAL MODEMS FOR BURST-MODE TRANSMISSIONS", IEEE TRANSACTIONS ON COMMUNICATIONS, IEEE SERVICE CENTER, PISCATAWAY, NJ. USA, vol. 43, no. 2/04, PART 02, 1 février 1995 (1995-02-01), pages 1169-1178, XP000502606, ISSN: 0090-6778, DOI: 10.1109/26.380149 cité dans la demande**
- **RODRIGUE IMAD ET AL: "Blind Estimation of the Phase and Carrier Frequency Offsets for LDPC-Coded Systems", EURASIP JOURNAL ON ADVANCES IN SIGNAL PROCESSING, vol. 2010, no. 1, 1 décembre 2010 (2010-12-01), XP055498267, DOI: 10.1155/2010/293572 cité dans la demande**

**Description**

## DOMAINE TECHNIQUE

La présente invention appartient au domaine de la détection d'un signal utile émis par un dispositif émetteur. Plus particulièrement, la présente invention concerne la détection de signaux utiles dans le cas où chaque signal utile peut être affecté d'une dérive fréquentielle non négligeable, par exemple supérieure à une largeur spectrale dudit signal utile.

Par « largeur spectrale » du signal utile, on entend la largeur du spectre fréquentiel instantané du signal utile. La largeur spectrale dudit signal utile est donc indépendante de la dérive fréquentielle.

## ÉTAT DE LA TECHNIQUE

La présente invention trouve une application particulièrement avantageuse, bien que nullement limitative, dans le cas de signaux utiles dits à « bande étroite » pour lesquels la largeur spectrale est typiquement inférieure à 2 kilohertz, voire inférieure à 1 kilohertz.

Dans le cas de signaux utiles à bande étroite, de nombreux phénomènes peuvent introduire une dérive fréquentielle supérieure à la largeur spectrale desdits signaux utiles.

Tout d'abord, les signaux utiles étant reçus par un dispositif récepteur, des déplacements relatifs du dispositif émetteur par rapport au dispositif récepteur peuvent induire, par effet Doppler, des dérives fréquentielles qui peuvent s'avérer non négligeables par rapport à la largeur spectrale des signaux utiles si les vitesses relatives de déplacement sont importantes. De telles dérives fréquentielles peuvent être introduites du fait d'une mobilité du dispositif émetteur et/ou d'une mobilité du dispositif récepteur.

Notamment, dans le cas d'un dispositif récepteur embarqué dans un satellite en orbite défilante, par exemple une orbite basse LEO, la vitesse de défilement dudit satellite par rapport au dispositif émetteur (fixe ou mobile à la surface de la Terre) peut introduire des dérives fréquentielles non négligeables des signaux utiles reçus au niveau dudit dispositif récepteur.

La dérive fréquentielle peut également être introduite dès l'émission, de manière non contrôlée. En effet, l'émission d'un signal utile nécessite d'équiper un dispositif émetteur de moyens de synthèse fréquentielle (oscillateur local, mélangeur, etc.) mis en œuvre pour translater en fréquences le signal utile, généré en bande de base, vers une bande fréquentielle d'émission des signaux utiles. De tels moyens de synthèse fréquentielle peuvent introduire une dérive fréquentielle qui, dans le cas notamment de signaux utiles à bande étroite, peut s'avérer non négligeable par rapport à la largeur spectrale desdits signaux utiles, en particulier dans le cas de dispositifs émetteurs bas coût pour lesquels les moyens de synthèse fréquentielle sont peu performants. Cependant, la dérive fréquentielle introduite par les moyens de synthèse fréquentielle est généralement faible par rapport à celle engendrée par les déplacements relatifs du dispositif émetteur par rapport au dispositif récepteur, en particulier si le signal utile est de faible durée.

Dans une moindre mesure, les moyens de synthèse fréquentielle du dispositif récepteur peuvent également introduire une dérive fréquentielle.

Une fois un signal utile détecté par le dispositif récepteur, c'est-à-dire notamment une fois que l'instant de début dudit signal utile a été estimé, il est alors nécessaire d'estimer et de compenser la dérive fréquentielle, mais également un décalage fréquentiel affectant ledit signal utile, afin de pouvoir extraire les données utiles incluses dans ledit signal utile.

L'estimation du décalage fréquentiel et de la dérive fréquentielle est complexe à effectuer, en particulier du fait qu'il est généralement nécessaire de limiter au maximum la quantité de données pilotes, connues a priori du dispositif récepteur, incluses dans le signal utile, afin de maximiser la quantité de données utiles émises.

En outre, le décalage fréquentiel et la dérive fréquentielle peuvent prendre de nombreuses valeurs différentes. Il est possible de mettre en œuvre des estimateurs au sens du maximum de vraisemblance, en testant toutes les valeurs possibles du décalage fréquentiel et toutes les valeurs possibles de la dérive fréquentielle. Toutefois, la quantité de calculs à effectuer et la quantité de données à mémoriser est alors très importante, et peut s'avérer rédhibitoire, en particulier pour la détection de signaux utiles au niveau d'un satellite.

Plusieurs méthodes de l'art antérieur reposent sur des estimations basées sur des données pilotes connues à la fois par le dispositif émetteur et par le dispositif récepteur : voir par exemple « An algorithm for Doppler shift and Doppler rate estimation based on pilot symbols » (Le Tian et al.), « Carrier frequency and frequency rate-of-change estimators with preamble-postamble pilot symbol distribution » (Giugno L. et al.), et la demande de brevet CN 106 817 333 A. De telles solutions conduisent cependant à une augmentation de la quantité de données à inclure dans le signal utile. Les demandes de brevet US 2013/083872 A1 et US 2008/143594 A1 présentent quant à elles des méthodes particulièrement complexes pour estimer la dérive fréquentielle et le décalage fréquentiel.

## EXPOSÉ DE L'INVENTION

La présente invention a pour objectif de remédier à tout ou partie des limitations des solutions de l'art antérieur, notamment celles exposées ci-avant, en proposant une solution qui permette d'estimer le décalage fréquentiel et la dérive fréquentielle affectant un signal utile de manière précise, tout en limitant la quantité de données pilotes à inclure dans le signal utile et en limitant la quantité de calculs à effectuer par rapport à une approche testant toutes les valeurs possibles du décalage fréquentiel et de la dérive fréquentielle.

A cet effet, et selon un premier aspect, l'invention concerne un procédé d'estimation d'un décalage fréquentiel et d'une dérive fréquentielle affectant un signal utile reçu par un dispositif récepteur, ledit signal utile comportant un mot de code formé par un codeur de canal à partir de données utiles. Le procédé d'estimation comporte une phase d'analyse comportant :

- pour deux dérives fréquentielles d'analyse : une compensation de la dérive fréquentielle d'analyse considérée sur le signal utile,
- une estimation du décalage fréquentiel sur chaque signal utile obtenu après compensation, de sorte à obtenir des décalages fréquentiels d'analyse associés respectivement aux dérives fréquentielles d'analyse, définissant deux points d'analyse dans un plan dérive fréquentielle / décalage fréquentiel,
- une sélection d'hypothèses fréquentielles sur une droite déterminée par les deux points d'analyse.

Le procédé d'estimation comporte en outre une phase d'estimation comportant :

- pour chaque hypothèse fréquentielle : un recalage fréquentiel du signal utile en fonction de l'hypothèse fréquentielle considérée, pour obtenir des séquences d'échantillons associées respectivement aux hypothèses fréquentielles,
- une évaluation de la probabilité de chaque séquence d'échantillons d'être un mot de code dudit codeur de canal,
- une estimation du décalage fréquentiel et de la dérive fréquentielle affectant le signal utile en fonction de l'hypothèse fréquentielle associée à la séquence d'échantillons présentant la plus forte probabilité d'être un mot de code du codeur de canal.

Ainsi, le procédé d'estimation comporte principalement deux phases, une phase d'analyse et une phase d'estimation.

La phase d'analyse vise à sélectionner des hypothèses fréquentielles à tester au cours de la phase d'estimation, une hypothèse fréquentielle étant définie comme étant une paire constituée par une valeur possible de dérive fréquentielle et une valeur possible de décalage fréquentiel ou, en d'autres termes, un point dans un plan dérive fréquentielle / décalage fréquentiel.

Au cours de la phase d'analyse, deux dérives fréquentielles d'analyse prédéterminées différentes sont compensées sur le signal utile, et deux décalages fréquentiels d'analyse sont estimés à partir des signaux utiles obtenus après compensation. Ces étapes permettent d'obtenir deux points d'analyse dans le plan dérive fréquentielle / décalage fréquentiel.

Le nombre d'hypothèses fréquentielles à tester est alors réduit en faisant l'hypothèse que la dérive fréquentielle réelle et le décalage fréquentiel réel affectant le signal utile forment un point qui doit se trouver sur la droite formée, dans le plan dérive fréquentielle / décalage fréquentiel, par les deux points d'analyse. Les inventeurs ont constaté que cette hypothèse est particulièrement bien vérifiée dans le cas où le décalage fréquentiel est estimé au moyen d'un estimateur non biaisé. Dans le cas d'un estimateur biaisé, cette hypothèse n'est plus nécessairement vérifiée, mais peut néanmoins permettre d'avoir une précision acceptable compte tenu de la réduction de complexité permise par la réduction du nombre d'hypothèses fréquentielles à tester.

Au cours de la phase d'estimation, les différentes hypothèses fréquentielles sont testées en recalant fréquentiellement le signal utile et en obtenant, pour chaque hypothèse fréquentielle, une séquence d'échantillons censée représenter un mot de code d'un codeur de canal utilisé par le dispositif émetteur pour former le signal utile. Pour déterminer l'hypothèse fréquentielle la plus probable, les séquences d'échantillons obtenues sont évaluées pour déterminer laquelle correspond avec la plus forte probabilité à un mot de code du codeur de canal.

Ainsi, la phase d'estimation peut être mise en œuvre de manière aveugle, sans utiliser de données pilotes, en utilisant les propriétés du codeur de canal. En effet, si une hypothèse fréquentielle n'est pas suffisamment proche de la dérive fréquentielle réelle et du décalage fréquentiel réel affectant le signal utile, alors la séquence d'échantillons obtenue après recalage fréquentiel devrait en principe être assez éloignée des mots de code du codeur de canal et donc présenter une faible probabilité de correspondre à un mot de code du codeur de canal.

Dans des modes particuliers de mise en œuvre, le procédé d'estimation peut en outre comporter l'une ou plusieurs des caractéristiques suivantes, prises isolément ou selon toutes les combinaisons techniquement possibles.

Dans des modes particuliers de mise en œuvre, l'évaluation de la probabilité d'une séquence d'échantillons comporte un calcul d'un syndrome souple de ladite séquence d'échantillons.

Dans des modes particuliers de mise en œuvre, l'évaluation de la probabilité d'une séquence d'échantillons comporte, pour chaque séquence d'échantillons, un calcul de vraisemblance d'échantillons, le syndrome souple de ladite séquence d'échantillons étant calculé en fonction des vraisemblances desdits échantillons.

Dans des modes particuliers de mise en œuvre, le codeur de canal met en œuvre un code convolutionnel, un turbo-code ou un code à contrôle de parité de faible densité.

Selon un second aspect, l'invention concerne un produit programme d'ordinateur comportant un ensemble d'instructions de code de programme qui, lorsqu'elles sont exécutées par un processeur, configurent ledit processeur pour mettre en œuvre un procédé d'estimation selon l'un quelconque des modes de mise en œuvre de l'invention.

Selon un troisième aspect, l'invention concerne un dispositif récepteur comportant un circuit de traitement configuré pour mettre en œuvre un procédé d'estimation selon l'un quelconque des modes de mise en œuvre de l'invention.

Selon un quatrième aspect, l'invention concerne un satellite destiné à être placé en orbite défilante, comportant un dispositif récepteur selon l'un quelconque des modes de réalisation de l'invention.

## PRÉSENTATION DES FIGURES

L'invention sera mieux comprise à la lecture de la description suivante, donnée à titre d'exemple nullement limitatif, et faite en se référant aux figures qui représentent :

- Figure 1 : une représentation schématique d'un exemple de réalisation d'un système de réception de signaux utiles,
- Figure 2 : une représentation schématique d'un exemple de réalisation d'un dispositif récepteur,
- Figure 3 : un diagramme représentant les principales étapes d'un procédé d'estimation de décalage fréquentiel et de dérive fréquentielle affectant un signal utile selon l'invention,
- Figure 4 : un diagramme représentant un plan dérive fréquentielle / décalage fréquentiel et illustrant la sélection d'hypothèses fréquentielles pour la dérive fréquentielle et le décalage fréquentiel.

Dans ces figures, des références identiques d'une figure à une autre désignent des éléments identiques ou analogues. Pour des raisons de clarté, les éléments représentés ne sont pas à l'échelle, sauf mention contraire.

## DESCRIPTION DÉTAILLÉE DE MODES DE RÉALISATION

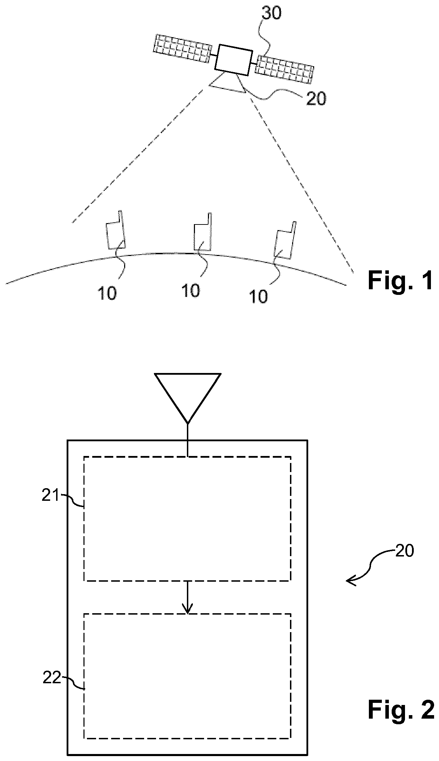

La figure 1 représente schématiquement un exemple de réalisation d'un système de réception de signaux utiles.

Dans l'exemple non limitatif illustré par la figure 1, les signaux utiles correspondent à des signaux radioélectriques émis par des dispositifs émetteurs 10 sensiblement à la surface de la Terre. Par « sensiblement à la surface de la Terre », on entend que chaque dispositif émetteur 10 est au sol (terrestre ou maritime), ou bien en altitude dans l'atmosphère terrestre (embarqué dans un avion, un drone, un ballon, etc.). Les signaux utiles sont émis dans une bande de fréquences, et l'invention est applicable dans n'importe quelle bande de fréquences, notamment les bandes de fréquences traditionnellement utilisées dans les systèmes de télécommunications terrestres ou par satellite.

Un signal utile émis par un dispositif émetteur 10 comporte notamment un mot de code formé par un codeur de canal à partir de données utiles qui doivent être émises par le dispositif émetteur 10, lesdites données utiles n'étant pas connues a priori du dispositif récepteur 20. De manière connue, un codeur de canal rajoute de la redondance pour permettre, au niveau du dispositif récepteur 20 de détecter et éventuellement de corriger des erreurs de transmission. Par exemple, le codeur de canal met en œuvre un code convolutionnel, un turbo-code, un code à contrôle de parité de faible densité (« Low Density Parity Check » ou LDPC dans la littérature anglo-saxonne), etc.

Dans la suite de la description, et tel qu'illustré par la figure 1, on se place de manière non limitative dans le cas où le dispositif récepteur 20 est embarqué dans un satellite 30 en orbite terrestre. Rien n'exclut cependant, suivant d'autres exemples, d'avoir un dispositif récepteur 20 embarqué dans un engin spatial ou aérien (avion, drone, ballon, etc.). Le dispositif récepteur 20 peut également, suivant d'autres exemples, être au sol (terrestre ou maritime) et recevoir les signaux utiles directement des dispositifs émetteurs 10, ou indirectement par exemple par l'intermédiaire du satellite 30. L'invention est également applicable, notamment, dans le cas où c'est le dispositif émetteur 10 qui est embarqué dans un satellite 30, le dispositif récepteur 20 étant au sol.

Le satellite 30 est de préférence en orbite défilante, par exemple en orbite basse altitude LEO (« Low Earth Orbit »). Rien n'exclut cependant de considérer d'autres types d'orbites, par exemple une orbite moyenne altitude MEO (« Medium Earth Orbit »), voire une orbite non défilante telle qu'une orbite géostationnaire GEO (« Geostationary Orbit »), etc.

Chaque dispositif émetteur 10 peut être fixe ou mobile. De même, le dispositif récepteur 20 peut être fixe ou mobile.

Tel qu'indiqué précédemment, chaque signal utile reçu par le dispositif récepteur 20 peut être affecté d'une dérive fréquentielle, par exemple induite dans l'exemple illustré par la figure 1 par le défilement du satellite 30 par rapport aux dispositifs émetteurs 10. Dans la suite de la description, on se place de manière non limitative dans le cas où la dérive fréquentielle est supérieure à la largeur spectrale dudit signal utile. Par « largeur spectrale » du signal utile, on entend la largeur du spectre fréquentiel instantané du signal utile.

Dans la suite de la description, on se place de manière non limitative dans le cas où les signaux utiles sont à bande étroite, c'est-à-dire de largeur spectrale égale ou inférieure à 2 kilohertz, de préférence égale ou inférieure à 1 kilohertz. L'invention est également applicable pour d'autres types de signaux utiles, toutefois on comprend que, pour de tels signaux utiles, une dérive fréquentielle peut facilement devenir non négligeable.

La figure 2 représente schématiquement un exemple de réalisation d'un dispositif récepteur 20. Tel qu'illustré par la figure 2, le dispositif récepteur 20 comporte un circuit 21 radioélectrique et un circuit 22 de traitement.

Le circuit 21 radioélectrique comporte des moyens, considérés comme connus de l'homme de l'art, permettant la réception de signaux utiles émis par des dispositifs émetteurs 10. Ces moyens comportent par, notamment, une ou plusieurs antennes, un ou plusieurs amplificateurs, un ou plusieurs oscillateurs locaux, un ou plusieurs mélangeurs, etc.

Le circuit 22 de traitement est adapté notamment à traiter les signaux utiles reçus par le circuit 21 radioélectrique, éventuellement après conversion analogique / numérique desdits signaux utiles.

Le circuit 22 de traitement comporte par exemple un ou plusieurs processeurs et des supports de mémorisation (disque dur magnétique, mémoire électronique, disque optique, etc.) dans lesquels est mémorisé un produit programme d'ordinateur, sous la forme d'un ensemble d'instructions de code de programme à exécuter pour mettre en œuvre, notamment, tout ou partie des étapes d'un procédé 50 d'estimation de décalage fréquentiel et de dérive fréquentielle affectant un signal utile. Alternativement ou en complément, le circuit 22 de traitement comporte un ou des circuits logiques programmables (FPGA, PLD, etc.), et/ou un ou des circuits intégrés spécialisés (ASIC), et/ou un ensemble de composants électroniques discrets, etc., adaptés à mettre en œuvre tout ou partie des étapes du procédé 50 d'estimation.

En d'autres termes, le circuit 22 de traitement correspond à un ensemble de moyens configurés de façon logicielle (produit programme d'ordinateur spécifique) et/ou matérielle (FPGA, PLD, ASIC, etc.) pour mettre en œuvre les différentes étapes du procédé 50 d'estimation.

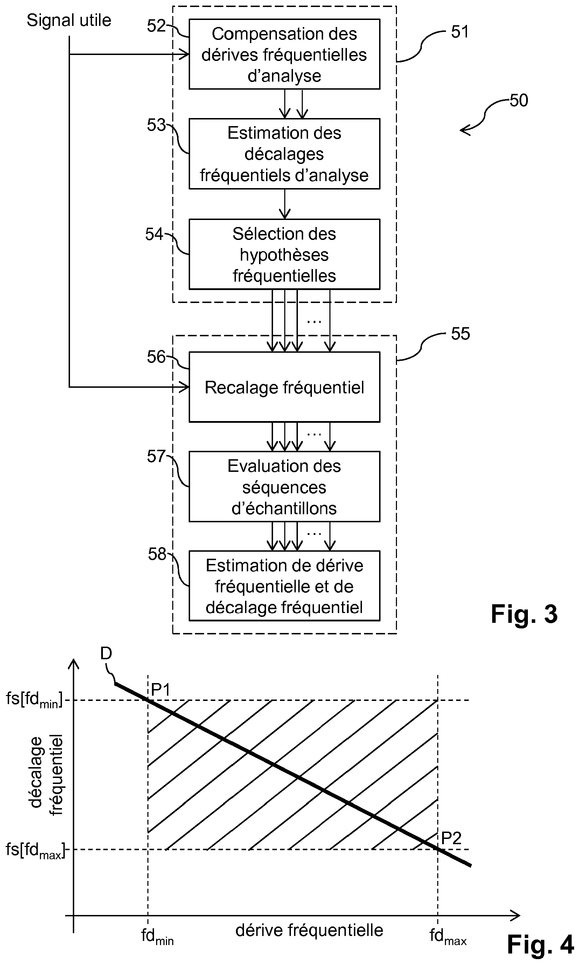

La figure 3 représente les principales étapes d'un procédé 50 d'estimation de décalage fréquentiel et de dérive fréquentielle affectant un signal utile. En principe, le procédé 50 d'estimation est mis en œuvre après avoir détecté le signal utile pour lequel on cherche à estimer le décalage fréquentiel et la dérive fréquentielle, et de préférence après avoir estimé l'instant de début dudit signal utile (synchronisation temporelle).

Tel qu'illustré par la figure 3, le procédé 50 d'estimation comporte principalement deux phases :

- une phase d'analyse 51 qui vise à sélectionner des hypothèses fréquentielles, une hypothèse fréquentielle étant définie comme étant une paire constituée par une valeur possible de dérive fréquentielle et une valeur possible de décalage fréquentiel ou, en d'autres termes, un point dans un plan dérive fréquentielle / décalage fréquentiel,
- une phase d'estimation 55 qui vise à identifier, parmi les hypothèses fréquentielles sélectionnées, l'hypothèse fréquentielle la plus probable ou vraisemblable au vu du signal utile reçu.

Tel qu'illustré par la figure 3, la phase d'analyse 51 comporte :

- pour au moins deux dérives fréquentielles d'analyse : une étape 52 de compensation de la dérive fréquentielle d'analyse considérée sur le signal utile,
- une étape 53 d'estimation du décalage fréquentiel sur chaque signal utile obtenu après l'étape 52 de compensation, de sorte à obtenir des décalages fréquentiels d'analyse associés respectivement aux dérives fréquentielles d'analyse, définissant deux points d'analyse P1 et P2 dans un plan dérive fréquentielle / décalage fréquentiel,
- une étape 54 de sélection d'hypothèses fréquentielles sur une droite déterminée par les deux points d'analyse.

La phase d'estimation 55 comporte :

- pour chaque hypothèse fréquentielle : une étape 56 de recalage fréquentiel du signal utile en fonction de l'hypothèse fréquentielle considérée, pour obtenir des séquences d'échantillons associées respectivement aux hypothèses fréquentielles,
- une étape 57 d'évaluation de la probabilité de chaque séquence d'échantillons d'être un mot de code dudit codeur de canal,
- une étape 58 d'estimation du décalage fréquentiel et de la dérive fréquentielle affectant le signal utile en fonction de l'hypothèse fréquentielle associée à la séquence d'échantillons présentant la plus forte probabilité d'être un mot de code du codeur de canal.

On décrit à présent des exemples détaillés de mise en œuvre des différentes étapes de la phase d'analyse 51 et de la phase d'estimation 55.

A) Phase d'analyse

A.1) Compensation des dérives fréquentielles d'analyse

Tel qu'indiqué précédemment, la phase d'analyse 51 comporte, pour au moins deux dérives fréquentielles d'analyse, une étape 52 de compensation de la dérive fréquentielle d'analyse considérée sur le signal utile.

En principe, dans le cas où la dérive fréquentielle est induite par le déplacement relatif du satellite 30 embarquant le dispositif récepteur 20 par rapport au dispositif émetteur 10, les valeurs possibles de la dérive fréquentielle sont bornées, comprises dans une plage fréquentielle dont les bornes peuvent être calculées a priori en mettant en oeuvre des méthodes connues de l'homme de l'art. Ainsi, en tenant compte de la vitesse de défilement du satellite 30 par rapport à la surface de la Terre, et d'une distance maximale entre une projection au sol de la trajectoire dudit satellite 30 et un dispositif émetteur 10 qui émet un signal utile reçu par ledit satellite, il est possible de calculer a priori une valeur maximale $fd_{max}$ et une valeur minimale $fd_{min}$ pour les dérives fréquentielles possibles. Dans un tel cas, lesdites dérives fréquentielles d'analyse correspondent de préférence respectivement à la valeur maximale $fd_{max}$ et à la valeur minimale $fd_{min}$ de la dérive fréquentielle, ou bien sont comprises dans la plage fréquentielle définie par ladite valeur maximale $fd_{max}$ et ladite valeur minimale $fd_{min}$ de la dérive fréquentielle.

Dans la suite de la description, on se place de manière non limitative dans le cas où les dérives fréquentielles d'analyse correspondent à la valeur maximale $fd_{max}$ et à la valeur minimale $fd_{min}$ de la dérive fréquentielle, calculées a priori en fonction des paramètres du système de réception. Par exemple, la valeur minimale $fd_{min}$ est égale à -15 Hz/s (Hertz par seconde), et la valeur maximale $fd_{max}$ est égale à 15 Hz/s.

Par exemple, en désignant par s(t) le signal utile reçu à l'instant t, et par respectivement $s_1(t)$ et $s_2(t)$ les signaux utiles obtenus après compensation par les deux dérives fréquentielles d'analyse, la compensation peut être effectuée selon l'expression suivante :

$$s_1(t) = s(t) \cdot \exp\left(-j \cdot \pi \cdot fd_{min} \cdot t^2\right)$$

$$s_2(t) = s(t) \cdot \exp\left(-j \cdot \pi \cdot fd_{max} \cdot t^2\right)$$

expression dans laquelle :

- j est l'unité imaginaire ($j^2$ = -1),
- exp(z) est la fonction exponentielle de la valeur z.

A.2) Estimation des décalages fréquentiels d'analyse

Tel qu'indiqué ci-dessus, la phase d'analyse 51 comporte en outre une étape 53 d'estimation des décalages fréquentiels affectant respectivement les signaux utiles $s_1(t)$ et $s_2(t)$ obtenus après compensation des dérives fréquentielles d'analyse sur le signal d'analyse s(t). Les décalages fréquentiels ainsi estimés sont désignés par décalages fréquentiels d'analyse.

Dans des modes préférés de mise en œuvre, les décalages fréquentiels d'analyse sont estimés au moyen d'un estimateur non biaisé. De manière générale, tout type d'estimateur de décalage fréquentiel non biaisé peut être mis en œuvre au cours de l'étape 53, et le choix d'un estimateur non biaisé particulier ne constitue qu'une variante possible d'implémentation. Notamment, il est possible, au cours de l'étape 53 d'estimation, d'utiliser des données pilotes, connues a priori du dispositif récepteur 20, éventuellement incluses par le dispositif émetteur 10 dans le signal utile. Des exemples non limitatifs d'estimateurs de décalage fréquentiel non biaisés sont par exemple connus des publications scientifiques suivantes :

- « Data-aided frequency estimation for burts digital transmission », U. Mengali et al., IEEE Transactions on Communications, Vol. 45, N°1, Janvier 1997,
- « Carrier frequency recovery in all-digital modems for burst-mode transmissions », M. Luise et al., IEEE Transactions on Communications, Vol. 43, N°3, Mars 1995,

- « Planar filtered techniques for burts mode carrier synchronization », M. P. Fitz, IEEE Globecom'91, Phoenix, Décembre 1991.

A l'issue de l'étape 53 d'estimation, on dispose donc d'un décalage fréquentiel d'analyse fs[$fd_{min}$] estimé à partir du signal utile $s_1(t)$, et d'un décalage fréquentiel d'analyse fs[$fd_{max}$] estimé à partir du signal utile $s_2(t)$, qui définissent deux points d'analyse P1 et P2 dans un plan dérive fréquentielle / décalage fréquentiel :

$$P1 = (fd_{min}, fs[fd_{min}])$$

$$P2 = (fd_{max}, fs[fd_{max}])$$

A.3) Sélection d'hypothèses fréquentielles

Tel qu'indiqué ci-dessus, la phase d'analyse 51 comporte en outre une étape 54 de sélection d'hypothèses fréquentielles. Une hypothèse fréquentielle correspond à un point dans un plan dérive fréquentielle / décalage fréquentiel, à tester au cours de la phase d'estimation 55.

Afin de réduire le nombre d'hypothèses fréquentielles à tester au cours de la phase d'estimation, les hypothèses fréquentielles sélectionnées sont de préférence toutes des points de la droite définie, dans le plan dérive fréquentielle / décalage fréquentiel, par les points d'analyse P1 et P2.

La figure 4 représente schématiquement les points d'analyse P1 et P2 dans le plan dérive fréquentielle / décalage fréquentiel, ainsi que la droite D définie par lesdits points d'analyse P1 et P2. En limitant les hypothèses fréquentielles à cette droite, l'estimation du décalage fréquentiel et de la dérive fréquentielle est ramenée d'un problème bidimensionnel (par exemple recherche de la meilleure hypothèse fréquentielle dans la surface hachurée définie par les valeurs $fd_{min}$ et $fd_{max}$, et fs[fdmax] et fs[fdmin]) à un problème monodimensionnel (par exemple recherche de la meilleure hypothèse fréquentielle sur le segment défini par les points d'analyse P1 et P2). Les inventeurs ont constaté que cette hypothèse selon laquelle la solution au problème se trouve sur la droite définie par les points d'analyse P1 et P2 est particulièrement bien vérifiée dans le cas où le décalage fréquentiel est estimé au moyen d'un estimateur non biaisé. Dans le cas d'un estimateur biaisé, cette hypothèse n'est plus nécessairement vérifiée, mais peut néanmoins permettre d'avoir une précision acceptable compte tenu de la réduction de complexité permise par la réduction du nombre d'hypothèses fréquentielles à tester.

Dans le cas où les dérives fréquentielles d'analyse correspondent à la valeur maximale $fd_{max}$ et à la valeur minimale $fd_{min}$ de la dérive fréquentielle, les hypothèses fréquentielles sont de préférence choisies sur le segment défini par les points d'analyse P1 et P2.

Un nombre $N_H$ d'hypothèses fréquentielles est sélectionné au cours de l'étape 54, le nombre $N_H$ étant par exemple de l'ordre de quelques dizaines, par exemple égal à 50. Par exemple, l'hypothèse fréquentielle de rang k ($1 \leq k \leq N_H$) consiste en une dérive fréquentielle $fd_k$ et en un décalage fréquentiel $fs_k$ déterminés selon les expressions suivantes :

$$fd_k = fd_{min} + (k-1) \cdot \frac{fd_{max} - fd_{min}}{N_H - 1}$$

$$fs_k = fs[fd_{min}] + (k-1) \cdot \frac{fs[fd_{max}] - fs[fd_{min}]}{N_H - 1}$$

Avec de telles expressions, l'hypothèse fréquentielle de rang 1 correspond au point d'analyse P1, et l'hypothèse fréquentielle de rang $N_H$ correspond au point d'analyse P2.

B) Phase d'estimation

Tel qu'indiqué précédemment, la phase d'estimation 55 vise à tester les $N_H$ hypothèses fréquentielles sélectionnées au cours de la phase d'analyse 51, afin d'identifier l'hypothèse fréquentielle la plus probable ou vraisemblable au vu du signal utile reçu, ce qui revient à estimer le décalage fréquentiel et la dérive fréquentielle affectant ledit signal utile reçu par le dispositif récepteur 20.

### B.1) Recalage fréquentiel du signal utile

Tel qu'indiqué ci-dessus, la phase d'estimation 55 comporte une étape 56 de recalage fréquentiel du signal utile en fonction de chaque hypothèse fréquentielle. L'étape 56 de recalage fréquentiel est comparable à l'étape 52 de compensation de la phase d'analyse, à ceci près qu'elle vise à compenser à la fois une dérive fréquentielle et un décalage fréquentiel.

Par exemple, en désignant par $s'_k(t)$ le signal utile obtenu par recalage fréquentiel en fonction de l'hypothèse fréquentielle $(fd_k, fs_k)$ de rang $k$ $(1 \leq k \leq N_H)$, le recalage fréquentiel peut être effectué selon l'expression suivante :

$$s'_k(t) = s(t) \cdot \exp\left(-j \cdot 2\pi \cdot \left(fs_k \cdot t + fd_k \cdot \frac{t^2}{2}\right)\right)$$

En pratique, le signal utile est un signal numérique, correspondant au signal $s(t)$ échantillonné à des instants d'échantillonnage séparés par une période d'échantillonnage $T_E$ prédéfinie. De manière nullement limitative, on considère que la période d'échantillonnage $T_E$ est égale à une période symbole Ts du signal utile, qui correspond à la durée entre deux symboles consécutifs du signal utile. Il est cependant possible de considérer une période d'échantillonnage $T_E$ supérieure à la période symbole Ts En outre, pour simplifier les équations, on considère uniquement la partie du signal utile qui correspond au mot de code formé, au niveau du dispositif émetteur 10, par le codeur de canal. Le nombre de symboles formant le mot de code est désigné ci-après par Ns, de sorte que la séquence d'échantillons $s'_k$ obtenue après recalage fréquentiel en fonction de l'hypothèse fréquentielle $(fd_k, fs_k)$ de rang $k$ $(1 \leq k \leq N_H)$ peut être exprimée sous la forme suivante $(1 \leq n \leq N_S)$ :

$$s'_k[n] = s[n] \cdot \exp\left(-j \cdot 2\pi \cdot \left(fs_k \cdot n \cdot T_E + fd_k \cdot \frac{(n \cdot T_E)^2}{2}\right)\right)$$

expression dans laquelle $s[n]$ est égal à $s(n \cdot T_E)$.

Les $N_H$ séquences d'échantillons $\{s'_k[n], 1 \leq n \leq Ns\}$ $(1 \leq k \leq N_H)$ sont par conséquent censées correspondre à un mot de code du codeur de canal. Il est à noter que, dans le cas de symboles à deux états (par exemple dans le cas d'une modulation de type BPSK ou « Binary Phase Shift Keying » dans la littérature anglo-saxonne), chaque échantillon d'une séquence représente un bit du mot de code. Dans le cas de symboles à M états (M>2), chaque échantillon d'une séquence représente plusieurs bits du mot de code. Il est alors possible, dans des modes particuliers de réalisation, d'effectuer en outre une démodulation de chaque signal utile obtenu après recalage fréquentiel, afin d'obtenir une séquence d'échantillons comportant au moins un échantillon par bit de mot de code. Une telle démodulation doit, le cas échéant, être à sortie en valeur souples (« soft output demodulation » dans la littérature anglo-saxonne). Rien n'exclut cependant, suivant d'autres exemples, de considérer des séquences d'échantillons dans lesquelles chaque échantillon d'une séquence représente plusieurs bits du mot de code.

Dans la suite de la description, on se place de manière non limitative dans le cas où les séquences d'échantillons $\{s'_k[n], 1 \leq n \leq Ns\}$ $(1 \leq k \leq N_H)$ comportent un échantillon par bit de mot de code, de sorte que le nombre Ns correspond en outre au nombre de bits d'un mot de code.

### B.2) Evaluation des séquences d'échantillons

Tel qu'indiqué ci-dessus, la phase d'estimation 55 comporte ensuite une étape 57 d'évaluation de la probabilité de chaque séquence d'échantillons d'être un mot de code dudit codeur de canal.

L'étape 57 d'évaluation vise à quantifier la probabilité de chacune des $N_H$ séquences d'échantillons de correspondre à un mot de code du codeur de canal. En effet, de manière connue de l'homme de l'art, un codeur de canal rajoute de la redondance de manière structurée. Ainsi, la probabilité d'une séquence d'échantillons de correspondre à un mot de code du codeur de canal correspond à une grandeur représentative de la mesure dans laquelle ladite séquence d'échantillons vérifie la structure imposée par le codeur de canal.

Dans le cas d'un codeur de canal linéaire, la structure dudit codeur de canal est par exemple déterminée de manière connue par la matrice de contrôle de parité dudit codeur de canal, et l'évaluation de chaque séquence d'échantillons peut être effectuée en fonction de ladite matrice de contrôle parité dudit codeur de canal.

Afin d'évaluer la probabilité d'une séquence d'échantillons de correspondre à un mot de code du codeur de canal, il est possible de mettre en œuvre des méthodes issues de la théorie du codage de canal, et le choix d'une méthode particulière ne constitue qu'une variante d'implémentation possible de l'étape 57 d'évaluation.

Par exemple, il est possible, dans des modes préférés de mise en œuvre, de calculer un syndrome souple de chaque séquence d'échantillons. Un exemple de calcul de syndrome souple est connu de la publication scientifique suivante, dans le contexte d'un codeur de canal de type LDPC et d'une estimation aveugle d'un décalage fréquentiel affectant un signal utile : « Blind estimation of the phase and carrier frequency offset for LDPC coded systems », R. Imad et al., EURASIP Journal on Advances in Signal Processing, Volume 2010, Article ID 293572.

De manière connue de l'homme de l'art, dans le cas d'un codeur de canal linéaire, il est possible de définir une matrice de contrôle de parité H. Si le nombre de bits en entrée du codeur de canal est égal à $N_B$ et le nombre de bits en sortie est égal à Ns, alors la matrice de contrôle de parité H est de dimension $(Ns - N_B) \times N_S$. Le syndrome $\sigma$ d'une séquence r de Ns bits est un vecteur de dimension $(Ns - N_B)$, comportant les éléments $\{\sigma[j], 1 \leq j \leq (Ns - N_B)\}$, défini par l'expression suivante :

$$\sigma(r) = r \cdot H^T$$

expression dans laquelle $H^T$ correspond à la matrice transposée de la matrice de contrôle de parité H.

Si la séquence r de Ns bits est un mot de code du codeur de canal, alors le syndrome $\sigma(r)$ est le vecteur nul. Dans le cas contraire, le syndrome $\sigma(r)$ est différent du vecteur nul.

Par conséquent, il est possible au cours de l'étape 57 d'évaluation, d'évaluer la probabilité d'une séquence d'échantillons d'être un mot de code comme étant une norme du syndrome souple de ladite séquence d'échantillons. La séquence d'échantillons présentant par exemple la norme de syndrome souple la plus faible peut alors être considérée comme étant la séquence d'échantillons qui présente la probabilité la plus élevée d'être un mot de code du codeur de canal.

Pour calculer le syndrome souple d'une séquence d'échantillons, il est par exemple possible de calculer une vraisemblance de chaque échantillon de cette séquence. Généralement, dans le domaine des codeurs de canal, une telle vraisemblance est calculée sous la forme d'un rapport de vraisemblance logarithmique (« Log-Likelihood Ratio » dans la littérature anglo-saxonne, voir par exemple la publication scientifique mentionnée ci-dessus, des auteurs R. Imad et al.). Le calcul de telles vraisemblances est considéré comme connu de l'homme de l'art, et le choix d'une méthode de calcul particulière ne constitue qu'une variante d'implémentation de l'étape 57 d'évaluation.

Par exemple, chaque élément $\tilde{\sigma}_k[p]$ $(1 \leq p \leq (N_S - N_B))$ du syndrome souple $\tilde{\sigma}_k$ de la séquence d'échantillons $s'_k$ de rang k est calculé selon l'expression suivante :

$$\tilde{\sigma}_k[p] = (-1)^{u_p+1} \cdot \arg\tanh\left(\prod_{n=1}^{u_p} \tanh\left(\frac{\tilde{s}_k[p_n]}{2}\right)\right) \qquad (1)$$

expression dans laquelle :

- tanh(z) est la fonction tangente hyperbolique de la valeur z,
- argtanh(z) est la fonction argument tangente hyperbolique de la valeur z, fonction réciproque de la fonction tangente hyperbolique,
- $\tilde{s}_k[n]$ est la vraisemblance de l'élément $s'_k[n]$ de rang n de la séquence d'échantillons $s'_k$,
- $p_n$ est l'indice du n-ième élément non nul de la p-ième ligne de la matrice de contrôle de parité H,
- $u_p$ est le nombre d'éléments non nuls de la p-ième ligne de la matrice de contrôle de parité H.

Pour réduire la quantité de calculs, il est possible d'approcher l'expression (1) par l'expression suivante :

$$\tilde{\sigma}_k[p] = (-1)^{u_p+1} \cdot \left(\prod_{n=1}^{u_p} \mathrm{sign}(\tilde{s}_k[p_n])\right) \cdot \min_{n=1,\ldots,u_p} |\tilde{s}_k[p_n]| \qquad (2)$$

Par exemple, l'évaluation de la séquence d'échantillons se poursuit en calculant une norme du syndrome souple. Par exemple, la grandeur $\varphi_k$ représentative de la probabilité qu'a la séquence d'échantillons $s'_k$, associée à l'hypothèse fréquentielle de rang k, d'être un mot de code du codeur de canal est calculée selon l'expression suivante :

$$\varphi_k = \sum_{p=1}^{N_S - N_B} \tilde{\sigma}_k[p] \qquad (3)$$

En considérant l'expression (3) ci-dessus, la séquence d'échantillons la plus probable est alors celle qui minimise la grandeur $\varphi_k$.

Il est à noter que dans le cas où le codeur de canal est suivi d'un poinçonneur, qui supprime certains bits du mot de code à l'émission, il n'est pas possible d'appliquer directement l'expression (2) ci-dessus. Dans un tel cas, il est possible par exemple de définir une matrice de contrôle de parité partielle H', qui correspond à la matrice de contrôle de parité H à laquelle il a été supprimé les colonnes correspondant aux bits poinçonnés. Les différents éléments du syndrome souple sont par exemple calculés selon l'expression (1) ci-dessus. En désignant par $N_P$ le nombre d'éléments du syndrome souple ($N_P \leq (N_S - N_B)$), il est alors possible de calculer, comme grandeur représentative de la probabilité qu'a la séquence d'échantillons $s'_k$ d'être un mot de code du codeur de canal, l'information mutuelle $IM_k$ portée par ce syndrome souple, par exemple selon l'expression suivante :

$$IM_k = 1 - \frac{1}{N_P} \sum_{p=1}^{N_P} \frac{\exp\left(\frac{|\tilde{\sigma}_k(p)|}{2}\right)}{\exp\left(\frac{|\tilde{\sigma}_k(p)|}{2}\right) + \exp\left(-\frac{|\tilde{\sigma}_k(p)|}{2}\right)} \qquad (4)$$

En considérant l'expression (4) ci-dessus, la séquence d'échantillons la plus probable est alors celle qui maximise la grandeur $IM_k$.

De manière plus générale, il est possible de calculer d'autres grandeurs représentatives de la probabilité qu'a une séquence d'échantillons d'être un mot de code. Suivant un autre exemple non limitatif, il est possible de calculer la distance minimale entre la séquence d'échantillons considérée et un mot de code du codeur de canal. Dans un tel cas, la séquence d'échantillons la plus probable est celle qui minimise ladite distance minimale.

B.3) Estimation du décalage fréquentiel et de la dérive fréquentielle

Tel qu'indiqué ci-dessus, la phase d'estimation 55 comporte en outre une étape 58 d'estimation du décalage fréquentiel et de la dérive fréquentielle affectant le signal utile.

En pratique, la dérive fréquentielle et le décalage fréquentiel estimés correspondent de préférence à l'hypothèse fréquentielle associée à la séquence d'échantillons la plus probable, c'est-à-dire ayant par exemple minimisé la grandeur $\varphi_k$ ou maximisé la grandeur $IM_k$. Toutefois, il est également possible, suivant d'autres exemples, de considérer par exemple les deux hypothèses fréquentielles associées aux deux séquences d'échantillons les plus probables, et d'estimer par exemple la dérive fréquentielle et le décalage fréquentiel comme étant une moyenne (éventuellement pondérée) desdites deux hypothèses fréquentielles si celles-ci sont voisines sur la droite D définie par les points d'analyse P1 et P2.

## Revendications

1. Procédé (50) d'estimation d'un décalage fréquentiel et d'une dérive fréquentielle affectant un signal utile reçu par un dispositif récepteur (20), ledit signal utile comportant un mot de code formé par un codeur de canal à partir de données utiles, ledit procédé comportant une phase d'analyse (51) comportant :

- pour deux dérives fréquentielles d'analyse : une compensation (52) de la dérive fréquentielle d'analyse considérée sur le signal utile,
- une estimation (53) du décalage fréquentiel sur chaque signal utile obtenu après compensation, de sorte à obtenir des décalages fréquentiels d'analyse associés respectivement aux dérives fréquentielles d'analyse, définissant deux points d'analyse dans un plan dérive fréquentielle / décalage fréquentiel,
- une sélection (54) d'hypothèses fréquentielles sur une droite (D) déterminée par les deux points d'analyse,

et une phase d'estimation (55) comportant :

- pour chaque hypothèse fréquentielle : un recalage fréquentiel (56) du signal utile en fonction de l'hypothèse fréquentielle considérée, pour obtenir des séquences d'échantillons associées respectivement aux hypothèses fréquentielles,
- une évaluation (57) de la probabilité de chaque séquence d'échantillons d'être un mot de code dudit codeur de canal,
- une estimation (58) du décalage fréquentiel et de la dérive fréquentielle affectant le signal utile en fonction de l'hypothèse fréquentielle associée à la séquence d'échantillons présentant la plus forte probabilité d'être un mot de code du codeur de canal.

2. Procédé (50) selon la revendication 1, dans lequel l'évaluation de la probabilité d'une séquence d'échantillons comporte un calcul d'un syndrome souple de ladite séquence d'échantillons.

3. Procédé (50) selon la revendication 2, dans lequel l'évaluation de la probabilité d'une séquence d'échantillons comporte, pour chaque séquence d'échantillons, un calcul de vraisemblance d'échantillons, le syndrome souple de ladite séquence d'échantillons étant calculé en fonction des vraisemblances desdits échantillons.

4. Procédé (50) selon l'une des revendications précédentes, dans lequel le codeur de canal est un code convolutionnel, un turbo-code ou un code à contrôle de parité de faible densité.

5. Procédé (50) selon l'une des revendications précédentes, dans lequel le décalage fréquentiel est estimé (53), sur chaque signal utile après compensation, au moyen d'un estimateur non biaisé.

6. Produit programme d'ordinateur **caractérisé en ce qu'**il comporte un ensemble d'instructions de code de programme qui, lorsqu'elles sont exécutées par un processeur, configurent ledit processeur pour mettre en œuvre un procédé (50) d'estimation selon l'une des revendications précédentes.

7. Dispositif récepteur (20), **caractérisé en ce qu'**il comporte un circuit (22) de traitement configuré pour mettre en œuvre un procédé (50) d'estimation de décalage fréquentiel et de dérive fréquentielle affectant un signal utile selon l'une des revendications 1 à 5.

8. Satellite (30) destiné à être placé en orbite défilante, **caractérisé en ce qu'il** comporte un dispositif récepteur (20) selon la revendication 7.

**Patentansprüche**

1. Verfahren (50) zur Schätzung eines Frequenzversatzes und einer Frequenzabweichung, die ein Nutzsignal betreffen, das von einer Empfängervorrichtung (20) empfangen wird, wobei das Nutzsignal ein Codewort beinhaltet, das durch einen Kanalkodierer aus Nutzdaten gebildet wird, wobei das Verfahren eine Analysephase (51) beinhaltet, Folgendes beinhaltend:

   - für zwei Analysefrequenzabweichungen: eine Kompensation (52) der betrachteten Analysefrequenzabweichung auf dem Nutzsignal,
   - eine Schätzung (53) des Frequenzversatzes auf jedem nach der Kompensation erhaltenen Nutzsignal, um Analysefrequenzversätze zu erhalten, die jeweils den Analysefrequenzabweichungen zugewiesen sind, die zwei Analysepunkte in einer Frequenzversatz-/ Frequenzabweichungsebene definieren,
   - eine Auswahl (54) an Frequenzhypothesen auf einer Geraden (D), die durch die beiden Analysepunkte bestimmt wird,

   und eine Schätzungsphase (55), Folgendes beinhaltend:

   - für jede Frequenzhypothese: eine Frequenzneueinstellung (56) des Nutzsignals in Abhängigkeit von der betrachteten Frequenzhypothese, um Sample-Sequenzen zu erhalten, die jeweils den Frequenzhypothesen zugeordnet sind,
   - eine Bewertung (57) der Wahrscheinlichkeit jeder Sample-Sequenz, ein Codewort des Kanalkodierers zu sein,
   - eine Schätzung (58) des Frequenzversatzes und der Frequenzabweichung, die das Nutzsignal betreffen, in Abhängigkeit von der Frequenzhypothese, die der Sample-Sequenz zugewiesen ist, die die größte Wahrscheinlichkeit aufweist, ein Codewort des Kanalkodierers zu sein.

2. Verfahren (50) nach Anspruch 1, wobei die Bewertung der Wahrscheinlichkeit einer Sample-Sequenz eine Berechnung eines flexiblen Syndroms der Sample-Sequenz beinhaltet.

3. Verfahren (50) nach Anspruch 2, wobei die Bewertung der Wahrscheinlichkeit einer Sample-Sequenz für jede Sample-Sequenz eine Sample-Wahrscheinlichkeitsberechnung beinhaltet, wobei das flexible Syndrom der Sample-Sequenz in Abhängigkeit von den Wahrscheinlichkeiten der Samples berechnet wird.

4. Verfahren (50) nach einem der vorstehenden Ansprüche, wobei der Kanalkodierer ein Faltungscode, ein Turbo-Code oder ein Code für Paritätskontrolle geringer Dichte ist.

5. Verfahren (50) nach einem der vorstehenden Ansprüche, wobei der Frequenzversatz auf jedem Nutzsignal nach dem Kompensieren anhand eines erwartungstreuen Schätzers geschätzt (53) wird.

6. Computerprogrammprodukt, **dadurch gekennzeichnet, dass** es eine Reihe von Programmcodeanweisungen beinhaltet, die, wenn sie von einem Prozessor ausgeführt werden, den Prozessor konfigurieren, um ein Verfahren (50) zur Schätzung nach einem der vorstehenden Ansprüche umzusetzen.

7. Empfängervorrichtung (20), **dadurch gekennzeichnet, dass** sie eine Verarbeitungsschaltung (22) beinhaltet, die konfiguriert ist, um ein Verfahren (50) zur Schätzung eines Frequenzversatzes und einer Frequenzabweichung, die ein Nutzsignal betreffen, nach einem der Ansprüche 1 bis 5 umzusetzen.

8. Satellit (30), der dazu bestimmt ist, in der nichtstationären Umlaufbahn platziert zu werden, **dadurch gekennzeichnet, dass** er eine Empfängervorrichtung (20) nach Anspruch 7 beinhaltet.

**Claims**

1. A method (50) for estimating a frequency shift and a frequency drift affecting a useful signal received by a receiving device (20), said useful signal including a code word formed by a channel encoder from useful data, said method comprising an analysis phase (51) including:

   - for two analysis frequency drifts: a compensation (52) of the considered analysis frequency drift on the useful signal,
   - an estimation (53) of the frequency shift on each useful signal obtained after compensation, so as to obtain analysis frequency shifts associated respectively with the analysis frequency drifts, defining two analysis points in a frequency drift / frequency shift plane,
   - a selection (54) of frequency hypotheses on a straight line (D) determined by the two analysis points,

   and an estimation phase (55) including:

   - for each frequency hypothesis: a frequency recalibration (56) of the useful signal depending on the considered frequency hypothesis, in order to obtain sample sequences associated respectively with the frequency hypotheses,
   - an evaluation (57) of the probability of each sample sequence to be a code word of said channel encoder,
   - an estimation (58) of the frequency shift and the frequency drift affecting the useful signal depending on the frequency hypothesis associated with the sample sequence having the highest probability of being a code word of the channel encoder.

2. The method (50) according to claim 1, wherein the evaluation of the probability of a sample sequence includes a calculation of a soft syndrome of said sample sequence.

3. The method (50) according to claim 2, wherein the evaluation of the probability of a sample sequence includes, for each sample sequence, a calculation of likelihood of samples, the soft syndrome of said sample sequence being calculated according to the likelihoods of said samples.

4. The method (50) according to one of the preceding claims, wherein the channel encoder is a convolutional code, a turbo-code or a low density parity check code.

**5.** The method (50) according to one of the preceding claims, wherein the frequency shift is estimated (53), on each useful signal after compensation, by means of an unbiased estimator.

**6.** A computer program product **characterised in that** it includes a set of program code instructions which, when executed by a processor, configure said processor to implement an estimation method (50) according to one of the preceding claims.

**7.** A receiving device (20), **characterised in that** it includes a processing circuit (22) configured to implement a method (50) for estimating a frequency shift and a frequency drift assigning a useful signal according to one of claims 1 to 5.

**8.** A satellite (30) intended to be placed in a travelling orbit, **characterised in that** it includes a receiving device (20) according to claim 7.

**Fig. 1**

**Fig. 2**

Signal utile

52 — Compensation des dérives fréquentielles d'analyse

51

50

53 — Estimation des décalages fréquentiels d'analyse

54 — Sélection des hypothèses fréquentielles

...

55

56 — Recalage fréquentiel

...

57 — Evaluation des séquences d'échantillons

...

58 — Estimation de dérive fréquentielle et de décalage fréquentiel

**Fig. 3**

**Fig. 4**

## RÉFÉRENCES CITÉES DANS LA DESCRIPTION

### Documents brevets cités dans la description

- CN 106817333 A
- US 2013083872 A1
- US 2008143594 A1

### Littérature non-brevet citée dans la description

- **LE TIAN.** *An algorithm for Doppler shift and Doppler rate estimation based on pilot symbols*
- **GIUGNO L.** *Carrier frequency and frequency rate-of-change estimators with preamble-postamble pilot symbol distribution*
- **U. MENGALI et al.** Data-aided frequency estimation for burts digital transmission. *IEEE Transactions on Communications,* Janvier 1997, vol. 45 (1
- **M. LUISE et al.** Carrier frequency recovery in all-digital modems for burst-mode transmissions. *IEEE Transactions on Communications,* Mars 1995, vol. 43 (3
- **M. P. FITZ.** Planar filtered techniques for burts mode carrier synchronization. *IEEE Globecom'91, Phoenix,* Décembre 1991
- **R. IMAD et al.** Blind estimation of the phase and carrier frequency offset for LDPC coded systems. *EURASIP Journal on Advances in Signal Processing,* vol. 2010